# EUROPÄISCHE PATENTANMELDUNG

(11) **EP 0 535 540 A2**
(43) Veröffentlichungstag der Anmeldung: **07.04.1993**
(21) Anmeldenummer: 92116389.5
(22) Anmeldetag: 24.09.1992
(51) Int. Cl.: C23F 4/00, H01L 21/321

(54) **Verfahren zum Ätzen einer Al-haltigen Schicht**

(30) Priorität: 02.10.1991 DE 4132838
(71) Anmelder: SIEMENS AKTIENGESELLSCHAFT, D-80333 München (DE)
(72) Erfinder: Grewal, Virinder, Dr., Fishkill, N.Y. 12524 (US); Schwarzl, Siegfried, Dr., W-8011 Neubiberg (DE)

(57) **Zusammenfassung**

Eine Al-haltige Schicht (5) wird in einer Reaktionskammer (1) einem Plasma ausgesetzt. Das Plasma wird aus einem Gasgemisch, das HCl-Gas und N₂-Gas enthält, gebildet. In der Reaktionskammer (1) herrscht ein Druck von mindestens 6,67 Pa (50 mTorr).

## Beschreibung

Zur Verbindung von Schaltelementen in integrierten Schaltungen werden Leiterbahnen aus Aluminium oder Aluminiumlegierungen verwendet. Diese Leiterbahnen werden durch Abscheidung einer aluminiumhaltigen Schicht und anschließende Strukturierung hergestellt. Die Strukturierung erfolgt in einem Trockenätzprozeß. An einen Trockenätzprozeß werden dabei folgende Anforderungen gestellt:
Bei der Strukturierung sollen sich senkrechte bzw. positiv geneigte Flanken ergeben. Bei der Ätzung sollen nur dünne Seitenwandpassivierungen durch Polymerisation entstehen. Der Ätzprozeß soll so geführt werden, daß die fertigen Leiterbahnen eine hohe Korrosionsbeständigkeit aufweisen. Im übrigen soll das Ätzverfahren fertigungsgerecht sein. Insbesondere sollen hohe Ätzraten erzielt werden. Der Ätzprozeß soll ein weites Prozeßfenster aufweisen. Diese Anforderungen sind besonders zur Herstellung von Leiterbahnen für VLSI-Schaltungen wichtig.

Beim Ätzen von Aluminium tritt das Problem auf, daß an der Aluminiumoberfläche im allgemeinen ein dünner Al₂O₃-Film vorhanden ist. Dieser Al₂O₃-Film muß vor der eigentlichen Aluminiumätzung entfernt werden.

Zur Strukturierung von aluminiumhaltigen Schichten bei der Herstellung von Aluminiumleiterbahnen ist bekannt (s. B. Chapman et al, Semiconductor International Nov. 1980, S. 139 ff.; A.J. Purdes, J. Vac. Sci. tech. Al(2) Apr.-June 1983, S. 712 ff.; Jer-shen Maa et al, J. Vac. Sci. Tech. B4(4) July/Aug. 1986, S 822 ff.; H.B. Bell et al, J. Electrochem. Soc., May 1988, S. 1184 ff., US-PS 3 994 793) chlorhaltige Gase wie BCl₃, SiCl₄, CCl₄ in Plasmaätzprozessen zu verwenden. Der Al₂O₃-Film wird mit diesen Gasen unter Anwendung intensiven Ionenbeschusses entfernt. Gleichzeitig wird die Restfeuchtigkeit aus der Ätzkammer entfernt. Die eigentliche Aluminiumätzung erfolgt in einem Cl₂-haltigen Hauptätzschritt. Durch Reaktion des Cl₂ mit zur Strukturierung verwendetem Photolack entstehen CCl-Polymere, die sich als Seitenwandpassivierung an Flanken der entstehenden Aluminiumstrukturen niederschlagen. Sie verhindern einen Ätzangriff an den Flanken und führen so zu einer Anisotropie des Cl₂-haltigen Hauptätzschrittes. Die Ätzung mit Cl₂ ist an sich isotrop. Nach Abschalten des Plasmas schreitet die Ätzung mit Cl₂ weiter fort, solange genügend Cl₂ im Ätzreaktor vorhanden ist. Dadurch wird eine Endpunktkontrolle der Ätzung erschwert. Darüberhinaus sind Gase wie BCl₃, SiCl₄ und CCl₄ korrosiv, schwer zu handhaben und deshalb fertigungsunfreundlich.

Der Erfindung liegt das Problem zugrunde, ein weiteres Verfahren zum Ätzen einer aluminiumhaltigen Schicht anzugeben, das fertigungsfreundlich ist und eine gute Endpunktkontrolle der Ätzung zuläßt.

Dieses Problem wird erfindungsgemäß gelöst durch ein Verfahren nach Anspruch 1.

In dem erfindungsgemäßen Verfahren wird ausgenutzt, daß sofern ein ausreichender Druck vorhanden ist, die Oberfläche der aluminiumhaltigen Schicht mit HCl-Molekülen vollständig belegt wird. HCl-Gas greift Aluminium nicht an. Erst durch Ionenbeschuß im Plasma dissoziiert das HCl an der Oberfläche der aluminiumhaltigen Schicht. Das dabei entstehende Cl führt zu einer Ätzung der Oberfläche. Bei genügend großem Druck in der Reaktionskammer wird die HCl-Belegung der Oberfläche der aluminiumhaltigen Schicht sofort wieder ergänzt.

In dem erfindungsgemäßen Verfahren ist die Ätzrate gekoppelt an die Brenndauer des Plasmas. Bei Abschalten des Plasmas findet keine Dissoziation von HCl an der Oberfläche der aluminiumhaltigen Schicht mehr statt, die Ätzung bricht daher sofort ab. Auf diese Weise ist eine gute Endpunktkontrolle der Ätzung gegeben.

Durch Zugabe geringer Mengen von Cl₂ wurde beobachtet, daß die Gleichmäßigkeit der Ätzung verbessert wird. Es liegt daher im Rahmen der Erfindung, dem Gasgemisch Cl₂ mit einem Gasfluß von 0 bis 50 sccm zuzugeben.

Unter dem Einfluß eines Magnetfeldes steigt die Aluminiumätzrate. Es wurde beobachtet, daß durch Anlegen eines Magnetfeldes mit einer magnetischen Flußdichte von 75 × 10⁻⁴ T (75 Gauß) die Ätzrate für Aluminium um 30 bis 40 % ansteigt gegenüber dem ohne Magnetfeld erzielten Wert. Es liegt daher im Rahmen der Erfindung, die Ätzung durch ein Magnetfeld mit einer magnetischen Flußdichte von 0 bis 100 × 10⁻⁴ T (100 Gauß) zu beeinflussen.

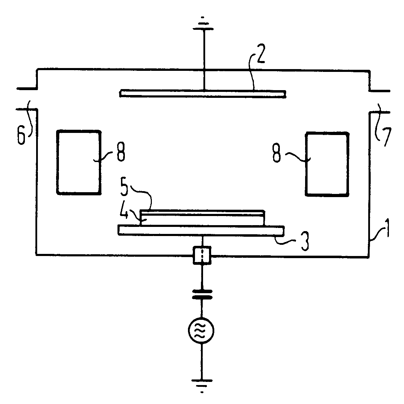

Weitere Ausgestaltungen der Erfindung gehen aus den übrigen Ansprüchen hervor. Im weiteren wird die Erfindung anhand der Figur und eines Ausführungsbeispiels näher erläutert.

In der Figur ist eine Reaktionskammer mit einer auf einem Substrat befindlichen aluminiumhaltigen Schicht dargestellt.

In einer Reaktionskammer 1, die vakuumdicht ist, sind eine obere Elektrode 2 und eine untere Elektrode 3 angeordnet. Zwischen der oberen Elektrode 2 und der unteren Elektrode 3 wird ein Hochfrequenzwechselfeld erzeugt. Auf der unteren Elektrode 3 ist ein Substrat 4 mit einer aluminiumhaltigen Schicht 5 angeordnet. Die aluminiumhaltige Schicht 5 soll strukturiert werden. Sie ist mit einer Photolackmaske versehen, die die Form der Strukturierung vorgibt (nicht dargestellt).

Über einen Gaseinlaß 6 und einen Gasauslaß 7 wird die Reaktionskammer 1 mit einem Gasgemisch beschickt. In der Reaktionskammer 1 kann darüberhinaus über Pole 8 von Permanentmagneten oder Elektrospulen (nicht dargestellt) ein Magnetfeld angelegt werden kann (s. Figur).

Zum Ätzen der aluminiumhaltigen Schicht 5 wird die Reaktionskammer 1 mit einem Gasgemisch, das HCl-Gas und N₂-Gas enthält, beschickt. Dabei wird in der Reaktionskammer ein Druck von 6,67 Pa (50 mTorr) bis 40 Pa (300 mTorr) eingestellt. Der HCl-Gasfluß beträgt dabei zwischen 50 und 300 sccm, der N₂-Gasfluß beträgt zwischen 50 und 200 sccm. Um die Gleichmäßigkeit der Ätzung zu verbessern, wird dem Gasgemisch Cl₂-Gas mit einem Gasfluß zwischen 0 und 50 sccm zugesetzt.

Zwischen der oberen Elektrode 2 und der unteren Elektrode 3 wird ein Hochfrequenzfeld mit einer Frequenz von 13,56 MHz und einer Leistung zwischen 300 und 500 Watt erzeugt. Die Ätzrate wurde durch ein Magnetfeld mit einer magnetischen Flußdichte im Bereich zwischen 0 und 100 x 10₋⁴ T (100 Gauß) erhöht.

Die besten Ergebnisse wurden auf einer Ätzanlage vom Typ P5000 der Firma Appl. Materials (das ist ein Mehrkammersystem mit Ätzkammern vom magnetfeldunterstützten RIE-Typ) mit folgendem Parametersatz erzielt:

| | |
|---|---|
| Druck in der Reaktionskammer: | 13 Pa (100 mTorr) |
| Hochfrequenzleistung bei 13,56 MHz: | 350 Watt |
| HCl-Gasfluß | 100 sccm |
| N₂-Gasfluß | 50 sccm |
| Cl₂-Gasfluß | 15 sccm |
| magnetische Flußdichte: | 75 x 10⁻⁴ T (75 Gauß). |

## Patentansprüche

1. Verfahren zum Ätzen einer Al-haltigen Schicht,
bei dem die Al-haltige Schicht (5) in einer Reaktionskammer (1) einem Plasma ausgesetzt wird,
- bei dem das Plasma aus einem Gasgemisch, das HCl-Gas und N₂-Gas enthält, gebildet wird,
- bei dem in der Reaktionskammer (1) ein Druck von mindestens 6,67 Pa (50 mTorr) herrscht.

2. Verfahren nach Anspruch 1,
bei dem der Druck in der Reaktionskammer (1) im Bereich von 6,67 Pa bis 40 Pa eingestellt wird.

3. Verfahren nach Anspruch 1 oder 2,
bei dem das HCl-Gas mit einem Gasfluß im Bereich von 50 bis 300 sccm durch die Reaktionskammer (1) geleitet wird.

4. Verfahren nach einem der Ansprüche 1 bis 3,
bei dem das N₂-Gas mit einem Gasfluß im Bereich von 50 bis 200 sccm durch die Reaktionskammer (1) geleitet wird.

5. Verfahren nach einem der Ansprüche 1 bis 4,
bei dem dem Gasgemisch Cl₂-Gas zugesetzt wird.

6. Verfahren nach Anspruch 5,
bei dem das Cl₂-Gas mit einem Gasfluß im Bereich von 0 bis 50 sccm durch die Reaktionskammer (1) geleitet wird.

7. Verfahren nach einem der Ansprüche 1 bis 6,
bei dem das Plasma mit Hilfe eines Magnetfeldes mit einer magnetischen Flußdichte im Bereich von 0 bis 100 x 10⁻⁴ T(100 Gauß) beeinflußt wird.

8. Verfahren nach einem der Ansprüche 1 bis 7,
bei dem das Plasma mit einer Hochfrequenz von 13,56 MHz und einer Hochfrequenzleistung im Bereich von 300 bis 500 Watt gezündet wird.

9. Verfahren nach einem der Ansprüche 1 bis 8,
bei dem die aluminiumhaltige Schicht (5) Beimengungen mindestens eines der Elemente Cu, Ti oder Si enthält.
